# DEMANDE DE BREVET EUROPEEN

(11) **EP 4 738 021 A1**
(43) Date de publication de la demande: **06.05.2026**
(21) Numéro de dépôt: 24210963.5
(22) Date de dépôt: 05.11.2024
(51) Int. Cl.: G04B 13/02, G04B 15/14, G04B 17/06, G04B 19/04

(54) **PROCÉDÉ DE FABRICATION DE COMPOSANTS EN SILICIUM**

(71) Demandeur: Sigatec SA, 1950 Sion (CH)
(72) Inventeur: Tille, Nicolas, 1965 Savièse (CH); Clivaz, Johannes, 1958 Uvrier (CH)
(74) Mandataire: BOVARD AG

(57) **Abrégé**

La présente invention se rapporte à un procédé de fabrication de composants horlogers (1) en silicium, où l'on fournit un substrat dans lequel on grave les composants (1), on désoxyde le substrat ainsi gravé dans un bain d'acide liquide, on réoxyde thermiquement le substrat, puis on le désoxyde une nouvelle fois par gravure à l'acide en phase vapeur.

## Description

### Domaine technique de l'invention

La présente invention concerne le traitement et la fabrication de composants en silicium, en particulier de composants horlogers tels que des spiraux, ancres, roues d'échappement, roues dentées, plateaux, aiguilles, balanciers.

### État de la technique

Les composants horlogers en silicium sont typiquement fabriqués à l'aide d'un substrat - aussi appelé wafer - de type silicium sur isolant connu sous l'acronyme SOI (silicon on insulator) et comprenant une couche utile de silicium dans laquelle les composants doivent être formés, une deuxième couche, typiquement en silicium, servant à rigidifier le substrat et, entre ces deux couches, une couche intermédiaire d'oxyde servant de couche d'arrêt pour les opérations de gravure de la couche utile.

Selon un procédé connu, la couche utile de silicium est gravée afin d'y former les composants puis une plaquette formée par au moins une partie de cette couche utile portant les composants est « libérée » c'est-à-dire détachée du substrat pour être soumise notamment à des opérations de traitement typiquement par oxydation thermique. L'oxydation vise par exemple à améliorer l'état de surface des composants, ajuster leurs dimensions et/ou leur raideur, et/ou augmenter leur résistance mécanique.

Un inconvénient lié à l'utilisation d'une plaquette portant les différents composants lors du ou des traitements est qu'en raison de sa faible épaisseur, la plaquette peut se déformer lors de la manipulation ou au cours du traitement. En conséquence, les composants horlogers peuvent également être déformés et ainsi rendus inutilisables.

D'autre part, il est quelquefois impossible de prévoir des attaches reliant les composants à la plaquette. C'est le cas notamment dans la fabrication de composants de petite taille. Dans ce cas les composants sont libérés du substrat sous la forme d'éléments unitaires, difficiles à manipuler et à traiter. Pour leur oxydation thermique, les composants doivent être déposés un à un sur un support, le support doit être transporté dans un four, puis, à l'issue de l'opération d'oxydation, les composants doivent à nouveau être retirés du support un à un.

### Résumé de l'invention

La présente invention propose un procédé de fabrication de composants horlogers permettant de résoudre les problèmes précités et de faciliter le traitement de composants horlogers, notamment leur traitement par oxydation thermique.

L'invention a pour objet un procédé de fabrication d'une pluralité de composants horlogers en silicium, comprenant au moins les étapes suivantes, réalisées dans cet ordre :
a) on fournit un substrat comprenant la superposition, dans une direction transversale, d'une couche utile de silicium, une couche intermédiaire d'oxyde et une couche de rigidification, la couche intermédiaire étant interposée entre la couche utile et la couche de rigidification,
b) on grave la couche utile pour y former les composants horlogers,
c) on désoxyde le substrat dans un bain d'acide liquide en conservant, en contact avec la face inférieure de chaque composant, au moins une zone utile de la couche intermédiaire,
d) on réoxyde thermiquement le substrat,
e) on désoxyde le substrat par gravure à l'acide en phase vapeur.

Il a en effet été constaté que l'acide liquide n'opère pas strictement de la même façon que le même acide en phase vapeur. L'acide liquide a plus de mal à attaquer l'oxyde sous les composants en silicium. Par conséquent, la désoxydation par bain permet de retirer de l'oxyde présent sur les composants tout en conservant une portion d'oxyde entre chaque composant et la couche intermédiaire.

Cette méthode a plusieurs avantages :
L'étape c) permet de supprimer l'oxyde présents sur les composants, par exemple les résidus d'un masque d'oxyde à travers lequel les composants ont été gravés ou de l'oxyde natif présent naturellement sur les composants, sans pour autant libérer les composants du reste du substrat. Les composants sont ainsi nettoyés de toute forme d'oxyde sur leur surface supérieure et leurs flancs latéraux mais restent tous solidaires de la couche intermédiaire et de la couche inférieure du substrat, laquelle confère sa rigidité au substrat. A l'étape d), le substrat peut alors être soumis à un traitement d'oxydation thermique, qui peut notamment viser à lisser les surfaces des composants horlogers ou à modifier les dimensions des composants.

Le procédé peut aussi permettre de réaliser à la suite une oxydation, une désoxydation puis une réoxydation du substrat portant les composants, sans nécessité de contrôler activement la désoxydation intermédiaire. La désoxydation par voie liquide ne risque pas d'éliminer la couche intermédiaire située sous les composants et d'aboutir à leur libération prématurée.

Dans certains cas particuliers, on peut toutefois choisir de stopper la désoxydation de l'étape c) à l'issue d'une période prédéterminée, ou encore de contrôler le retrait de l'oxyde lors de l'étape c) et de stopper la désoxydation de sorte que la zone de liaison de chaque composant conserve au moins une dimension supérieure à une valeur minimale prédéterminée.

Selon un mode de mise en oeuvre, le procédé peut comprendre une étape a0) d'oxydation du substrat, notamment une oxydation thermique du substrat, avant l'étape b) de gravure.

Dans ce cas notamment, la gravure des composants à l'étape b) peut être réalisée à travers au moins un masque d'oxyde.

Selon un mode de mise en oeuvre, le procédé peut aussi comprendre, entre les étapes b) et c), une première étape c0) d'oxydation thermique du substrat gravé.

A l'étape c), l'oxyde est retiré sauf sur la zone de liaison de chaque composant, puis une nouvelle étape d'oxydation thermique d) peut intervenir.

Il est aussi possible de répéter plusieurs fois la séquence c0)-c) et/ou de réaliser une ou plusieurs séquences c0)-c) après une première étape c).

Lors d'une étape d'oxydation c0) et/ou d), les composants horlogers ont leur surface inférieure en contact avec la couche intermédiaire. Sur les autres faces des composants où le silicium est libre et qui subissent l'oxydation, le front de silicium recule pour laisser la place à une couche de dioxyde de silicium. Les surfaces sont lissées et les dimensions brutes du composant en silicium sont modifiées.

Comme indiqué précédemment, l'oxydation thermique (d'une étape c0) et/ou d)) peut notamment viser un ajustement des dimensions ou un lissage des surfaces de composants.

Dans la présente demande, une oxydation de lissage doit être entendue comme une oxydation visant uniquement l'amélioration de l'état de surface des composants et dans laquelle la dimension de ces composants n'est pas prise en compte. En particulier, le choix de la durée de l'oxydation ou de la quantité de silicium à retirer des composants n'est pas conditionné par leurs dimensions.

Dans le cas d'un ajustement dimensionnel, au contraire, l'oxydation peut être réalisée en fonction d'une quantité de matière à retirer déterminée préalablement.

Par quantité de silicium, on entend en particulier une épaisseur (mesurée orthogonalement à la direction transversale) et/ou une hauteur (mesurée dans la direction transversale) de silicium des composants formés à l'étape b).

Typiquement, à l'étape b), les composants peuvent être formés avec des dimensions supérieures aux dimensions souhaitées. Par exemple, dans le cas d'un spiral, les dimensions des spiraux formés dans la couche utile lors de l'étape b) de gravure peuvent être supérieures aux dimensions nécessaires pour obtenir des spiraux ayant une certaine raideur cible.

Or, l'oxydation thermique du silicium entraîne la formation de dioxyde de silicium au détriment du silicium. Le front de silicium recule pour créer une nouvelle interface avec le dioxyde de silicium. Lorsque, lors de l'étape d) de désoxydation, la couche de dioxyde de silicium est éliminée, l'interface entre le silicium et le dioxyde de silicium devient la nouvelle surface extérieure du composant.

Notamment dans le cas où elle a une fonction de mise aux dimensions des composants, le procédé peut comprendre une étape préalable de mesure des composants gravés et de détermination de la quantité de matière à retirer pour obtenir des dimensions prédéterminées pour les composants. Dans ce cas, l'oxydation subséquente est réalisée en fonction de la quantité de matière à retirer ainsi déterminée.

Dans le cas d'une mise aux dimensions, l'effet de lissage est obtenu lui-aussi sur les faces oxydées, en tant qu'effet supplémentaire de l'oxydation/désoxydation.

Le procédé selon l'invention est particulièrement avantageux pour la fabrication de composants horlogers gravés sans attache. Dans ce cas, dans une direction orthogonale à la direction transversale, chaque composant horloger gravé à l'étape b) est délimité extérieurement par une face latérale formant un contour continu et fermé. Dans ce cas, la désoxydation de l'étape e) libère chaque composant individuellement.

Selon un autre exemple toutefois, les composants gravés à l'étape b) peuvent chacun être reliés par une attache au reste de la couche utile. Dans ce cas, l'étape e) entraîne la libération d'une plaquette comprenant tout ou partie de la couche utile et portant lesdits composants.

Selon un exemple, le procédé comprend en outre au moins une étape supplémentaire f) d'oxydation des composants horlogers libérés à l'étape e).

Selon une disposition avantageuse, l'étape d'oxydation f) peut comprendre le traitement suivant :
- on fournit un plateau de support dont une face utile forme, sur au moins une zone de réception, une surface d'accueil réalisée dans un matériau à base de nitrure et présentant une rugosité Ra supérieure à 50 nm, encore préférentiellement supérieure à 200 nm, encore préférentiellement supérieure à 1 micron,
- on place les composants horlogers (individualisés ou solidaires d'une plaquette) sur la surface d'accueil du plateau de support, et
- on soumet les composants horlogers placés sur ladite surface d'accueil à au moins une étape d'oxydation thermique,
avec la rugosité Ra de la surface d'accueil définie selon la norme ISO 4287.

Le plateau de support peut par exemple comprendre une âme sous forme de plaque et un revêtement réalisé dans un matériau à base de nitrure sur au moins une face de ladite plaque et formant la surface d'accueil.

Le matériau à base de nitrure est avantageusement du nitrure de silicium.

De préférence, la rugosité Ra de la surface d'accueil est inférieure à 50 microns, de préférence inférieure à 20 microns.

### Brève description des dessins

Les particularités et les avantages de la présente invention apparaîtront avec plus de détails dans le cadre de la description qui suit d'un exemple de mise en oeuvre donné à titre illustratif et non limitatif, en référence aux figures annexées :
Les figures 1a à 1l représentent différentes étapes du procédé selon l'exemple particulier décrit,
La figure 2 donne une séquence d'étapes, optionnelles ou non, du procédé.

### Description détaillée

Le procédé décrit ci-après est adapté pour la fabrication de tout type de composants horlogers en silicium, notamment des roues d'échappement, spiraux, ancres, roues dentées, plateaux, aiguilles, balanciers, éléments flexibles.

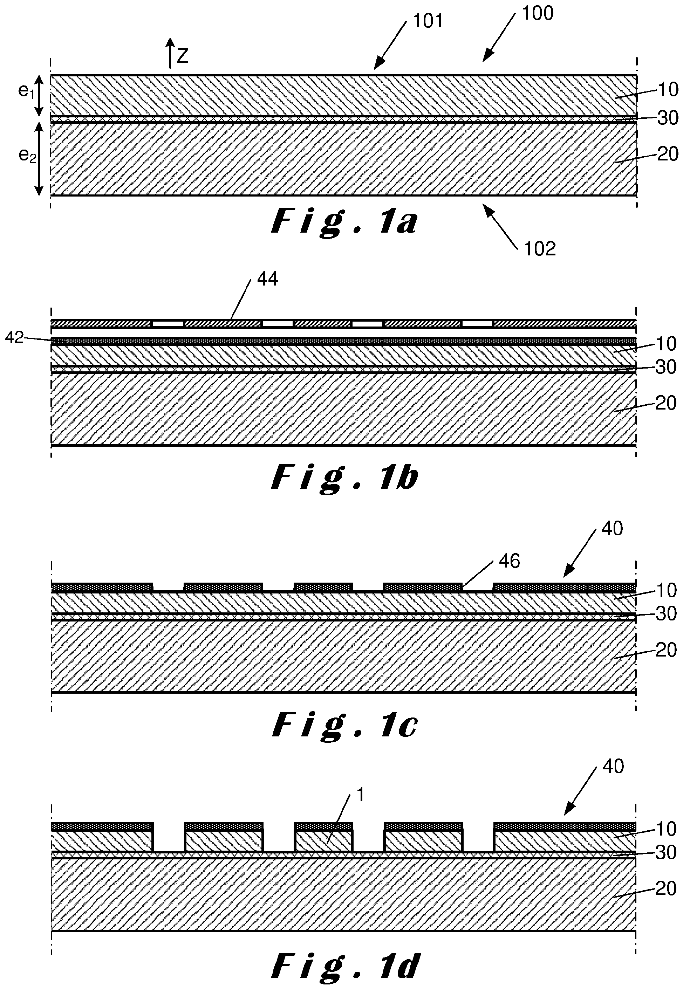

Une première étape a) du procédé consiste à fournir un substrat 100 (aussi couramment appelé wafer) adapté. Comme illustré sur la figure 1a, le substrat 100 est avantageusement de type silicium sur isolant (SOI), et comprend, entre un premier côté 101 et un deuxième côté 102, une couche utile de silicium 10 dans laquelle la ou les pièces doivent être formées, une couche intermédiaire 30 d'oxyde, typiquement de dioxyde de silicium (SiO₂), et une couche de rigidification 20, par exemple en silicium. On appelle direction transversale Z du substrat la direction dans laquelle ces trois couches sont superposées.

L'épaisseur e1 de la couche utile de silicium 10 dépend de l'épaisseur souhaitée pour les pièces à fabriquer. Elle peut par exemple être comprise entre 50 et 500µm.

La couche de rigidification 20 est généralement (mais non nécessairement) plus épaisse que la couche utile (e2 > e1), de sorte à assurer la rigidification du substrat.

La couche intermédiaire 30 forme une couche de liaison entre la couche utile 10 et la couche de rigidification 20.

Le procédé se poursuit par une étape b) de gravure des composants horlogers dans la couche utile du substrat.

Pour cela, un masque de gravure 40 est tout d'abord réalisé sur le premier côté 101 du substrat 100, comme illustré sur les figures 1b et 1c.

Le premier côté 101 du substrat 100 est d'abord recouvert d'une couche de résine photosensible 42, puis la couche de résine 42 est exposée à l'aide d'une source lumineuse (non illustrée), à travers un photomasque 44 représentant le motif souhaité (figure 1b). Par photolithographie, une pluralité d'ouvertures 46 est formée dans la couche de résine 42 (figure 1c). Ces ouvertures correspondent aux contours de la pluralité de composants 1 à fabriquer, à l'exception le cas échéant d'une portion non gravée ou attache conservée pour assurer la liaison entre le composant et le reste de la couche utile 10, comme décrit plus en détail dans la suite.

Par gravure ionique réactive profonde (aussi appelée gravure DRIE), la couche utile 10 du substrat 100 est ensuite gravée sur toute son épaisseur e1, sous les ouvertures 46 du masque 40, pour former les composants 1 (voir figure 1d).

Dans le contexte de l'invention, on définit pour chaque composant 1 une face supérieure 2a, une face inférieure 2b opposée à la face supérieure 2a dans la direction transversale Z et une face latérale 2c, avec la face inférieure 2b de chaque composant en contact avec la couche intermédiaire 30.

Dans certains cas, notamment dans le cas de composants 1 de petite taille, les composants gravés ont une face latérale 2c définissant un contour continu et fermé dans un plan orthogonal à la direction transversale Z. Autrement dit, la rainure de gravure externe délimitant les composants 1 forme une boucle fermée définissant la totalité du bord externe du composant.

Dans d'autres cas, la rainure de gravure externe correspond au bord du composant à l'exception d'une portion non gravée appelée attache assurant la liaison entre la pièce et le reste de la couche utile 10. Ces cas correspondent à ceux pour lesquels il est souhaité de libérer du substrat 100 une plaquette portant les composants horlogers plutôt que des composants individuels.

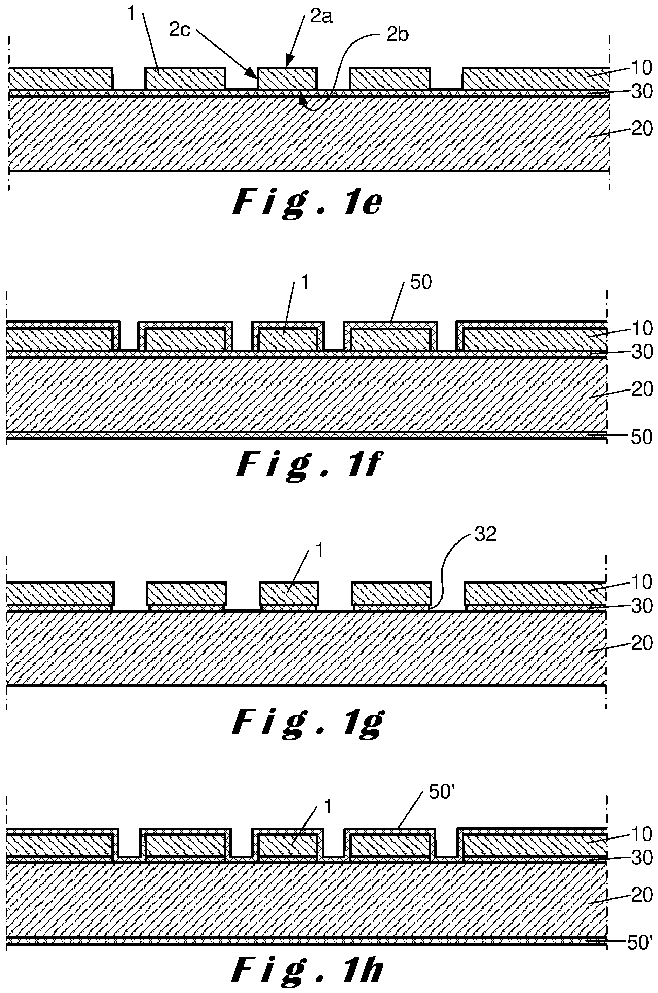

Comme illustré sur la figure 1e, la résine 42 peut ensuite être éliminée, notamment par nettoyage au plasma d'oxygène ou par nettoyage chimique, typiquement dans un bain ou sous l'effet d'un spray adapté.

Dans une variante non représentée de mise en oeuvre, le procédé pourrait comprendre, préalablement à l'étape b) de gravure, une étape a0) de réalisation d'une couche d'oxyde de silicium ou de nitrure, typiquement de nitrure de silicium, sur le substrat non gravé. Avantageusement, cette couche est une couche d'oxyde de silicium, obtenue par oxydation thermique du substrat. Dans ce cas, à l'étape b), cette couche d'oxyde ou de nitrure est gravée à travers les ouvertures de la résine pour former un masque supplémentaire, à travers lequel sera gravée la couche utile.

Cette variante peut notamment présenter un intérêt lorsque l'épaisseur à graver (e1) est importante, la résine photosensible, « consommée » lors de la gravure DRIE, pouvant dans ce cas ne pas suffire.

Dans une étape c0) illustrée sur la figure 1f, le substrat 100 peut éventuellement être oxydé thermiquement dans un four d'oxydation thermique chauffé à une température avoisinant généralement 1000°C. Lors de l'oxydation, sur toute les surfaces en silicium libres du substrat 100 (i.e. non recouvertes d'oxyde ou de nitrure) et notamment les faces supérieures 2a et latérales 2c des composants 1, une partie du silicium est consommé, laissant place à une couche de dioxyde de silicium 50.

Cette oxydation c0) peut avoir comme fonction de lisser les surfaces libres des composants, et en particulier leurs flancs latéraux 2c ou flancs de gravure qui sont souvent irréguliers dans le cas de la gravure de type DRIE.

Comme alternative, l'oxydation c0) peut aussi avoir pour fonction d'ajuster les dimensions des composants 1. L'homme de l'art sait dans quelle mesure le silicium est consommé lors de l'oxydation, et peut ainsi calculer en amont la durée de l'oxydation c0) en fonction de l'épaisseur de silicium à retirer sur les composants 1.

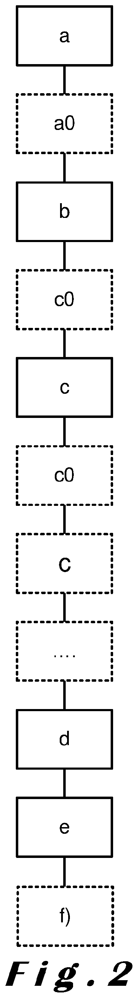

Alternativement, et comme il ressort de la figure 2, cette étape c0) peut aussi être omise.

Selon l'invention, le procédé se poursuit avec une étape c) de désoxydation illustrée sur la figure 1g, au cours de laquelle le substrat 100 est trempé dans un bain d'acide liquide, notamment un bain d'acide fluorhydrique.

La désoxydation dans de l'acide liquide a pour particularité d'épargner l'oxyde de la couche intermédiaire 30 situé sous les composants 1. Autrement dit, pour chaque composant 1, au moins une zone utile 32 de la couche intermédiaire 30 en contact avec sa face inférieure 2b n'est pas éliminée dans le bain d'acide.

L'oxyde présent sur les composants 1, soit issu d'un masque d'oxyde formé dans une étape a0), soit issu d'une étape c0) d'oxydation préalable comme décrit précédemment, soit formé naturellement sur le substrat 100 du fait du contact avec l'air ambiant (oxyde natif), est supprimé sur les faces latérales 2c et supérieures 2a des composants horlogers 1. Il en est de même, le cas échéant, d'un masque de nitrure tel que décrit précédemment.

On peut éventuellement stopper la désoxydation à l'issue d'une période de temps prédéterminée, ou encore contrôler le retrait de l'oxyde et stopper la désoxydation de sorte que la zone de liaison ou zone utile 32 de chaque composant 1 conserve au moins une dimension supérieure à une valeur minimale prédéterminée.

Toutefois, dans la mesure où la désoxydation dans un bain liquide n'attaque pas ou que très difficilement la couche intermédiaire sous les composants, le contrôle n'est pas nécessaire lors de la désoxydation (étape c).

A l'issue de cette étape de désoxydation, les composants 1 sont toujours liés, par les zones utiles 32 précitées, à la couche de rigidification 20 du substrat 100.

Le procédé comprend ensuite une nouvelle (ou première) étape d) d'oxydation du substrat (figure 1h où l'on voit la nouvelle couche de dioxyde de silicium 50' à la surface des composants 1), destinée à lisser les composants 1 ou à réaliser ou affiner un ajustement dimensionnel des composants 1.

On peut aussi réaliser plusieurs itérations de la séquence oxydation thermique / désoxydation (figures 1f/1g) dans un bain d'acide liquide, sans que les composants 1 ne soient pour autant détachés du substrat 100.

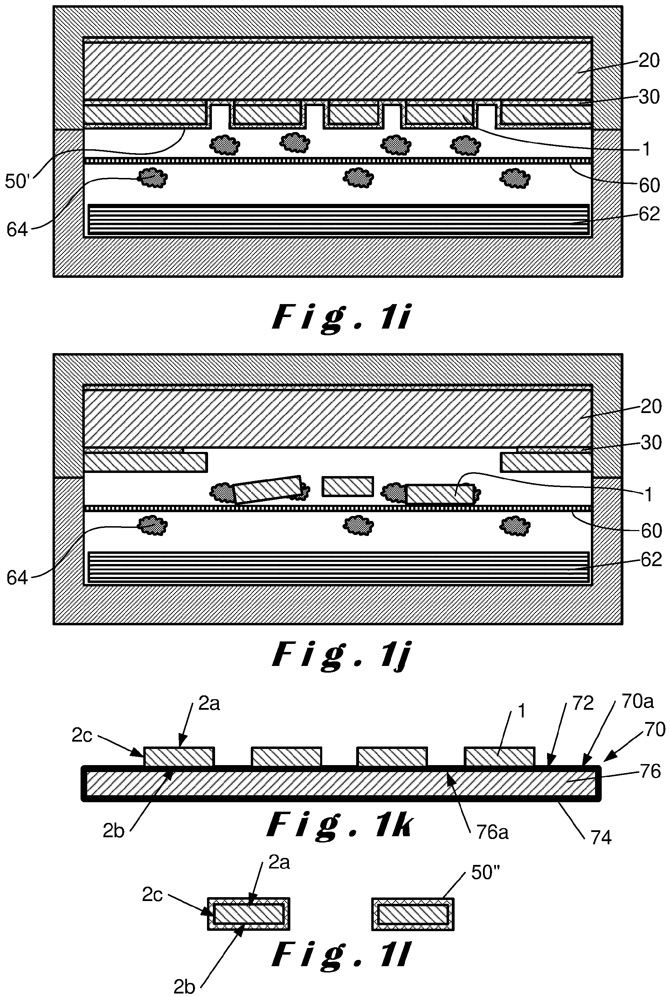

Enfin, le procédé comprend une étape e) de désoxydation du substrat 100 par gravure à l'acide en phase vapeur (figures 1i, 1j).

Lors de la gravure, la vapeur 64 issue d'un bain d'acide 62 sous-jacent, vient progressivement éliminer la zone utile 32 de la couche intermédiaire 30 située sous chaque composant 1. Lorsque les composants 1 ont été gravés sans attache comme dans l'exemple illustré, ils sont libérés individuellement du substrat 100, et recueillis sur une grille 60. Lorsqu'ils ont été gravés avec attache, c'est généralement une plaquette portant les composants 1 et comprenant tout ou partie de la couche utile 10 qui est détachée du reste du substrat 100.

Dans certains cas, il peut cependant être nécessaire de faire subir une nouvelle oxydation thermique f) aux composants 1 une fois libérés.

Comme illustré par la figure 1k et en particulier pour les composants gravés sans attache, cette oxydation peut avantageusement se faire à l'aide d'un plateau de support 70 dont une face utile 70a forme, sur au moins une zone de réception, une surface d'accueil 72 réalisée dans un matériau à base de nitrure et présentant une rugosité Ra supérieure à 50 nm, encore préférentiellement supérieure à 200 nm, encore préférentiellement supérieure à 1 micron.

Il a en effet été constaté qu'une telle surface d'accueil 72 pour les composants permet que la réaction d'oxydation se produise aussi au niveau de l'interface entre chaque composant 1 et la surface d'accueil 72 sans que les composants 1 ne restent collés sur cette surface à l'issue de l'oxydation. A l'issue du traitement, chaque composant 1 est entièrement recouvert de dioxyde de silicium 50" (i.e. sur toutes ses faces 2a, 2b et 2c, voir figure 1l).

Lors du traitement, on place les composants horlogers 1 sur la surface d'accueil 72 du plateau de support 70 et on soumet le composant horloger 1 placé sur ladite surface d'accueil 72 à au moins une étape d'oxydation thermique, dans un four adapté.

Selon une disposition avantageuse, le plateau de support 70 comprend une âme sous forme de plaque 76, typiquement en silicium, dont au moins une face 76a est recouverte d'un revêtement à base de nitrure 74 et ladite face 76a revêtue forme la surface d'accueil 72.

Grâce à l'utilisation du plateau spécifique 70, on peut oxyder des composants en silicium, même individuels, sur toutes leurs faces inférieures 2b, supérieures 2a et latérales 2c.

Dans le cas de composants solidaires d'une plaquette, le traitement sur plateau 70 de la plaquette permet d'éviter sa déformation et garantit ainsi une bonne qualité finale des composants.

## Revendications

1. Procédé de fabrication d'une pluralité de composants horlogers (1) en silicium, comprenant au moins les étapes suivantes, réalisées dans cet ordre :
a) on fournit un substrat (100) comprenant la superposition, dans une direction transversale (Z), d'une couche utile (10) de silicium, une couche intermédiaire d'oxyde (30) et une couche de rigidification (20), la couche intermédiaire (30) étant interposée entre la couche utile (10) et la couche de rigidification (20),
b) on grave la couche utile (10) pour y former les composants horlogers (1),
c) on désoxyde le substrat (100) dans un bain d'acide liquide en conservant, en contact avec la face inférieure (2b) de chaque composant (1), au moins une zone utile (32) de la couche intermédiaire (30),
d) on réoxyde thermiquement le substrat (100), puis
e) on désoxyde le substrat (100) par gravure à l'acide en phase vapeur.

2. Procédé selon la revendication 1, dans lequel, dans une direction orthogonale à la direction transversale, chaque composant horloger (1) gravé à l'étape b) est délimité extérieurement par une face latérale formant un contour continu et fermé.

3. Procédé selon la revendication 1 ou 2, comprenant en outre, avant l'étape c), une étape c0) d'oxydation thermique du substrat (100) gravé.

4. Procédé selon la revendication 3, comprenant au moins deux séquences des étapes c0) et c).

5. Procédé selon la revendication 3 ou 4, comprenant au moins une séquence des étapes c), c0) puis c).

6. Procédé selon l'une quelconque des revendications 1 à 5, comprenant en outre une étape a0) d'oxydation du substrat, avant l'étape b) de gravure.

7. Procédé selon l'une quelconque des revendications 1 à 6, dans lequel à l'étape b), la gravure des composants (1) est réalisée à travers au moins un masque d'oxyde.

8. Procédé selon l'une quelconque des revendications 1 à 7, dans lequel à l'étape b), on grave la couche utile par gravure ionique réactive profonde.

9. Procédé selon l'une quelconque des revendications 1 à 78, dans lequel on stoppe la désoxydation de la ou chaque étape c) à l'issue d'une période prédéterminée.

10. Procédé selon l'une quelconque des revendications 1 à 9, dans lequel lors de la ou chaque étape c), on contrôle le retrait de l'oxyde et on stoppe la désoxydation de sorte que la zone utile (32) de la couche intermédiaire (30) en contact avec la face inférieure (2b) de chaque composant (1) conserve au moins une dimension supérieure à une valeur minimale prédéterminée.

11. Procédé selon l'une quelconque des revendications 1 à 10, dans lequel l'oxydation de l'étape d) et/ou éventuellement de l'étape c0) est une oxydation de lissage des composants horlogers (1).

12. Procédé selon l'une quelconque des revendications 1 à 10, dans lequel l'oxydation de l'étape d) et/ou éventuellement de l'étape c0) est une oxydation de changement de dimensions des composants horlogers (1).

13. Procédé selon l'une quelconque des revendications 1 à 12, comprenant en outre une étape supplémentaire f) d'oxydation thermique des composants horlogers (1) libérés à l'étape e).

14. Procédé selon la revendication 13, dans lequel lors de l'étape f) :
- on fournit un plateau de support (70) dont une face utile forme, sur au moins une zone de réception, une surface d'accueil (72) réalisée dans un matériau à base de nitrure et présentant une rugosité Ra supérieure à 50 nm, encore préférentiellement supérieure à 200 nm, encore préférentiellement supérieure à 1 micron,
- on place les composants horlogers (1) sur la surface d'accueil (72) du plateau de support (70), et
- on soumet les composants horlogers (1) sur ladite surface d'accueil (72) à au moins une étape d'oxydation thermique.
